# EUROPEAN PATENT APPLICATION

(11) **EP 2 423 983 A2**
(43) Date of publication of application: **29.02.2012**
(21) Application number: 10194991.5
(22) Date of filing: 14.12.2010
(51) Int. Cl.: H01L 33/00, H01L 33/08, H01L 33/22

(54) **Light-emitting devices with two-dimensional composition-fluctuation active-region and method for fabricating the same**

(30) Priority: 30.08.2010 US 871604
(71) Applicant: Invenlux Limited, Central, HongKong (HK)
(72) Inventor: Zhang, Jianping, El Monte, CA 91731 (US); Yan, Chunhui, El Monte, CA 91731 (US)
(74) Representative: Price, Nigel John King

(57) **Abstract**

The present invention discloses a light-emitting device with a two-dimensional composition-fluctuation active-region (30) obtained via two-dimensional thermal conductivity modulation of the material lying below the active-region. The thermal conductivity modulation is achieved via formation of high-density pores (101) in the material below the active-region. The fabrication method of the light-emitting device and material with the high-density pores are also disclosed.

## Description

### FIELD OF THE TECHNOLOGY

The present invention relates in general to light-emitting devices, more particularly to light-emitting devices with two-dimensional (2D) composition-fluctuation active-regions.

### BACKGROUND

The active-region sandwiched between n-type layers and p-type layers of a light-emitting device plays a key role in the device's quantum efficiency. Better quantum confinement of non-equilibrium carriers in the active-region usually leads to greater recombination probability for light-generation. In the past decades, active-regions have been developed from three-dimensional (3D), to two-dimensional (2D), even to one- and zero- dimensional (ID, OD). A 3D active-region is made of a quasi bulk material without any quantum confinement effect, in which carriers can diffuse three-dimensionally and the electron-hole recombination probability is low. A 2D active-region introduces quantum confinement usually in the carrier-injection direction, commonly of multiple-quantum-well (MQW) configuration. 1D and OD active-regions implement additional quantum confinement in one and two more directions compared to a 2D active-region, with quantum wire and quantum dot active-regions as representatives. The electron-hole recombination probability increases as the confinement dimension increases. Therefore, OD, or quantum dot active-region is the most preferred active-region for low-threshold laser diodes and high intemal-quantum-efficiency (IQE) light-emitting diodes (LEDs).

The formation of self-assembled quantum dots in the prior art exclusively depends on strain. It is well-known that when an epilayer with larger in-plane lattice constant (*αₑₚᵢ*) is epitaxially grown on a substrate with smaller in-plane lattice constant (*α_{sub}*), the epilayer surface tends to be non-flat, in response to minimize the total free energy of the system. When the strain, *ε* = (*αₑₚᵢ-α_{sub}*)/ *α_{sub}* approaches 3%, three-dimensional, or, island growth mode is likely to initiate and quantum dots can be formed via the strain and growth time control. References regarding to self-assembled quantum dots can be found in US patent No. 7,618,905 and references therein.

Additionally, in the prior art, for example, in the published work done by Lin et al in Applied Physics Letters 97, 073101 (2010), there are disclosures on growth of active-regions directly on two-dimensionally confined templates, such as active-regions grown on nanorods, to form quantum disks as the active-region. US patent application publication No. 2007/0152353 also disclosed the direct deposition of InGaN quantum wells in porous GaN for better light generation efficiency, as US patent application publication No. 2009/0001416 has demonstrated that the rough surface feature of porous GaN can enhance indium incorporation for InGaN growth. It is believed that InGaN ultrathin films grown directly on top of porous GaN templates can possess quantum dots features for enhanced light-generation efficiency.

Porous materials have been explored in the prior art mainly for the purpose to improve material quality. For example, US patent No. 6,709,513 disclosed a method using porous anodic alumina as mask to grow better quality GaN. It is acknowledged that porous materials formed in the prior art have poor vertical alignment property, which means that pores in the prior art porous materials have poor vertical continuity and integrity. In the prior art, the porous material fabrication utilizes electrolytic treatment such as anodization. In general, a wafer of GaN, SiC, or Si is loaded into an electrochemical cell and is anodized in aqueous HF solution under direct current of a few to a few tens of milliamperes. To enhance the anodization process, a UV illumination of the etching surface is performed simultaneously. The pore size and density can be controlled by the anodic current. For example, porous silicon formation is disclosed in US patent No. 6,753,589 and references therein. Porous SiC formation is disclosed in US patent No. 5,298,767 and references therein, and porous GaN formation is disclosed in US patent 6,579,359, 7,462,893 and references therein

### SUMMARY

The present invention discloses new approaches to form self-assembled quantum dots as active-region for light-emitting devices. In general, the present invention discloses new approaches to form quantum wells with in-plane non-uniform composition caused by uneven temperature distribution on growth surface. More specifically, the present invention discloses new approaches to form quantum wells with in-plane non-uniform composition by taking advantage of the strong temperature dependence of indium incorporation on the temperature of growth surface. To achieve such a purpose, the present invention also discloses new methods to form porous materials with micro- and/or nano-pores.

One aspect of the present invention provides a light-emitting device, which comprises an n-type layer; a p-type layer; an active-region sandwiched between the n-type layer and the p-type layer, comprising at least one indium-containing quantum well layer, wherein indium composition of the indium-containing quantum well layer fluctuates in a growth surface from which the active-region grows; and a substrate having a first surface for receiving the active-region sandwiched between the n-type layer and the p-type layer; wherein the substrate has a solid portion and a porous portion, the porous portion contains pores configured to cause temperature fluctuation along the growth surface during epitaxial growth of the indium-containing quantum well that, in turn, causes the fluctuation of the indium composition of the indium-containing quantum well layer.

Preferably, the pores of the substrate are continuous pores extending along a direction substantially perpendicular to the growth surface.

Preferably, the porous portion contains pores of diameter from 200 nm to 10 micron with a pore density from 10⁶ to 10⁹ cm⁻². Preferably, the porous portion is of a thickness from 5 to 100 micron.

Preferably, the pores are open to a second surface of the substrate which is opposite to the first surface.

Preferably, the porous portion is bonded on the solid portion of the substrate.

Preferably, the porous portion is a susceptor of an epitaxy reactor holding the solid portion of the substrate during epitaxial growth of the active-region.

Another aspect of the present invention provides a light-emitting device, which comprises an n-type layer; a p-type layer; an active-region sandwiched between the n-type layer and the p-type layer, comprising at least one indium-containing quantum well layer, wherein indium composition of the indium-containing quantum well layer fluctuates along a growth surface from which the active-region grows; a template layer having a first surface for receiving the active-region sandwiched between the n-type layer and the p-type layer; and a substrate for receiving the template layer thereon; wherein the template layer contains pores configured to cause temperature fluctuation along the growth surface during epitaxial growth of the indium-containing quantum well layer that, in turn, causes the fluctuation of the indium composition of the indium-containing quantum well layer.

Preferably, the pores of the template layer extend along a direction substantially perpendicular to the growth surface.

Preferably, the template layer is of a thickness from 1 to 10 micron.

Preferably, the template layer is made of GaN, or AlGaN, or InGaN.

In one embodiment, the pores of the template layer have a diameter from 5 nm to 50 nm with a pore density from 10⁸ to 10⁹ cm⁻².

In another embodiment, the pores of the template layer have a diameter from 0.2 to 1 micron with a pore density from 10⁶ to 10⁹ _{cr}ri ².

Preferably, the pores are continuous pores open to a second surface of the template layer which is opposite to the first surface. If desirable, the pores can be also open to the first surface.

Another aspect of the present invention provides a method for fabricating a light-emitting device, which comprised forming pores in a substrate with a pore density from 10⁶ to 10⁹ cm⁻²; depositing an n-type layer on the substrate; forming an active-region comprising at least one indium-containing quantum well layer on the n-type layer, wherein indium composition of the indium-containing quantum well layer fluctuates along a growth surface from which the active-region grows; and depositing a p-type layer on the active-region; wherein the pores are configured to cause temperature fluctuation along a growth surface during epitaxial growth of the indium-containing quantum well layer on the growth surface that, in turn, causes the fluctuation of the indium composition of the indium-containing quantum well layer.

Preferably, the step of forming pores in the substrate comprises forming an anodic alumina mask on the substrate; subjecting the substrate with the anodic alumina mask to a scanning laser beam to form the pores in the substrate; and removing the anodic alumina mask.

Preferably, the step of forming pores in the substrate comprises forming a mask on the substrate by a nanoprint lithographic process; subjecting the substrate with the mask to ion-implantation to form defective zones in the substrate; removing the defective zones by a wet chemical etch process to form the pores in the substrate; and removing the mask.

Preferably, the ion implantation comprises implanting ions selected from the group consisting of hydrogen, helium, nitrogen, and oxygen ions with a dose over 10¹² cm-² , an implantation time over 2 minutes, and an ion energy over 50 KeV.

Another aspect of the present invention provides a method for fabricating a light-emitting device, which comprises forming a porous template layer with a pore density from 10⁶ to 10⁹ cm⁻² on a substrate; depositing an n-type layer on the porous template layer; forming an active-region comprising at least one indium-containing quantum well layer on the n-type layer, wherein indium composition of the indium-containing quantum well layer fluctuates along a growth surface from which the active-region grows; and depositing a p-type layer on the active-region; wherein the pores of the porous template layer are configured to cause temperature fluctuation in a growth surface during epitaxial growth of the indium-containing quantum well layer on the growth surface that, in turn, causes the fluctuation of the indium composition of the indium-containing quantum well layer.

Preferably, the step of forming the porous template layer comprises depositing a template layer on the substrate; depositing indium-containing islands over the template layer; depositing a mask layer on the template layer and the indium-containing islands; subjecting the mask layer and the indium-containing islands to a temperature sufficient to remove the indium-containing islands and portions of the mask layer that cover the indium-containing islands through thermal dissociation, so as to form a patterned mask layer exposing portions of the template layer; and etching the template layer by an etchant gas to form the porous template layer through the patterned mask layer.

Preferably, the indium-containing islands have a diameter or size of 5-50 nm, a density from 10⁸ to 10⁹ cm⁻² , and are made of InGaN with an indium composition from 10% to 50%;

Preferably, the mask layer and the indium-containing islands are subjected to a temperature above 850 °C to remove the indium-containing islands and portions of the mask layer that are deposited over the indium-containing islands through thermal dissociation,

Preferably, the mask layer is of thickness from 50-200 nm.

Preferably, the method further comprises a step of forming a regrwoth layer to seal openings of pores of the porous template generated in the step of etching the template layer.

Preferably, the mask layer is made of silicon nitride, or silicon dioxide.

Preferably, in the step of etching the template layer, an etch temperature is from 1000 to 1050 °C, an etch time is from 5 to 20 minutes, an etch pressure is from 100 to 760 torr, and a flow rate of the etchant gas is 5-50 seem.

### BRIEF DESCRIPTION OF THE DRAWINGS

The accompanying drawings, which are included to provide a further understanding of the invention and constitute a part of this application, illustrate embodiments of the invention and together with the description serve to explain the principle of the invention. Like reference numbers in the figures refer to like elements throughout, and a layer can refer to a group of layers associated with the same function.
FIG. 1 illustrates a method to form a porous material structure with substantially vertically aligned pores according to one aspect of the present invention.
FIGs. 2A-2C illustrate an approach to fabricate a porous material structure according to one aspect of the present invention.
FIGs. 3A-3G illustrate an approach to fabricate a porous template layer according to one aspect of the present invention.
FIG. 4 illustrates a light-emitting structure deposited on a substrate with a substantial vertically aligned porous portion.
FIG. 5 illustrates a light-emitting structure deposited over a surface of a substrate, wherein the opposing surface of the substrate is coated with or bonded to a porous material.
FIG. 6 illustrates a light-emitting structure deposited on a porous template layer over a substrate.
FIG. 7 illustrates a light-emitting structure deposited on a porous template layer over a substrate.
FIG. 8 illustrates a light-emitting structure deposited on a porous template layer over a substrate with a substantial vertically aligned porous portion.

### DETAILED DESCRIPTION

The present invention discloses new approaches to form self-assembled quantum dots as active-regions for light-emitting devices, utilizing the composition temperature dependence of alloyed compound semiconductors. Indium composition is very sensitive to deposition temperature during formation of indium-containing quantum well layers such as InGaN, InGaAs, InGaP quantum well layers. In the present invention, porosity is introduced in a substrate, a template layer, or some other portion of light-emitting devices below the indium-containing active-regions. Porosity of materials translates into a thermal conductivity discontinuity in the materials due to the difference in thermal conductivity between the solid portion and the pores of the porous material. As micro- and/or nano-sized pores are formed beneath and near the growth surface for an indium-containing active-region according to the present invention, a thermal conductivity difference is produced in the substrate or the template layer in a microscopic scope, which in turn causes a temperature fluctuation pattern on the growth surface corresponding to the pattern of pores under proper heating condition.

The principle of the present invention can be applied to light-emitting devices such as LEDs, laser diodes, and can also be applied to photo detector diodes by those who are skilled in the art based on the teachings in this specification. For convenience and simplicity, the inventors use InGaN-based LEDs as examples to describe the embodiments of the present inventions. It should be understood that the present invention is by no means limited to InGaN-based LEDs.

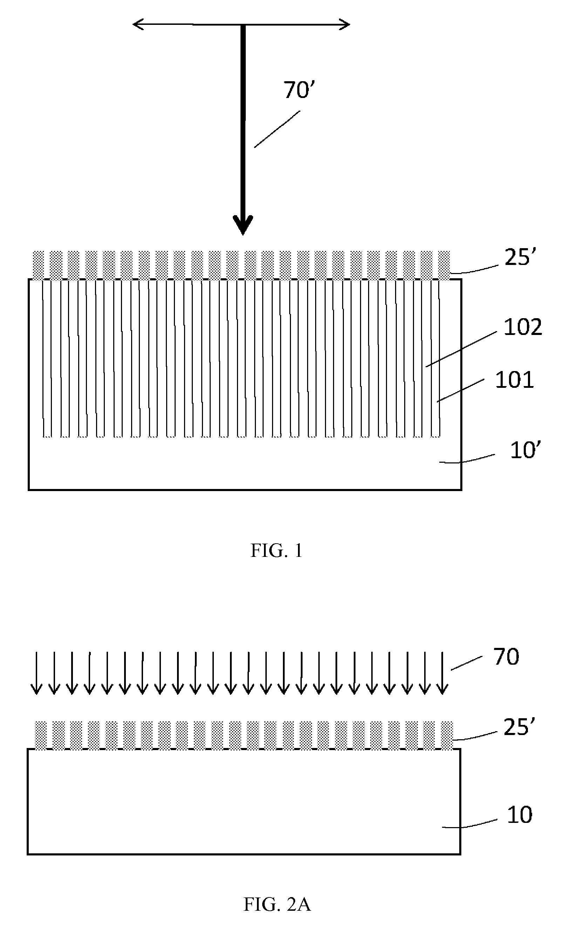

FIG. 1 illustrates an approach to make a porous material structure. Material of interest can be selected from GaN, Si, SiC, sapphire and the like. An anodic alumina mask 25' with high density pores is fabricated over substrate 10' by known methods, such as that described in US patent No. 6,139,713, which is herein incorporated by reference in its entirety. Then the surface of substrate 10' coated with mask 25' is subjected to high-power-density laser beams 70'. Because of the non-transparent nature of anodic alumina, laser energy can be transferred to substrate 10' through the nano pores of mask 25'. This process produces substantially vertically-aligned continuous pores in substrate 10', by laser-induced vaporization. The pore density of mask 25' can be over 10⁶ cm⁻², or over 1 Og cm⁻², or even over 10⁹ cm⁻², preferably in the range of 10⁸ cm⁻² to 10⁹ cm⁻² and the average diameter or size of the pores can be in the range of 0.2-10 µm. The porous portion of substrate 10' is composed of high density micro- or nano-sized pores 101 and solid walls 102. The depth of the pores 101 may be adjusted by varying the power of the laser beams70' and/or by varying the irradiation time thereof, and can be in the range of 5-100 µm, for example, 5-10 um in some embodiments, 50-100 uᵣn in some other embodiments.

When the substrate 10' in FIG. 1 is made of GaN or AlGaN, the scanning laser beam 70' can be a 355 nm line of the third harmonic from a Q-switched Nd:YAG pulse laser, or be a 248 nm line from the KrF excimer pulse laser. The pulsation for the laser beam can be from 5 ns to 50 ns with a power density from 300 to 600 mJ/cm2. Additionally, the laser beam 70' can be applied in one pulse or multiple pulses. The pores 101 in substrate 10' have a similar pore density and dimension as that of mask 25' .

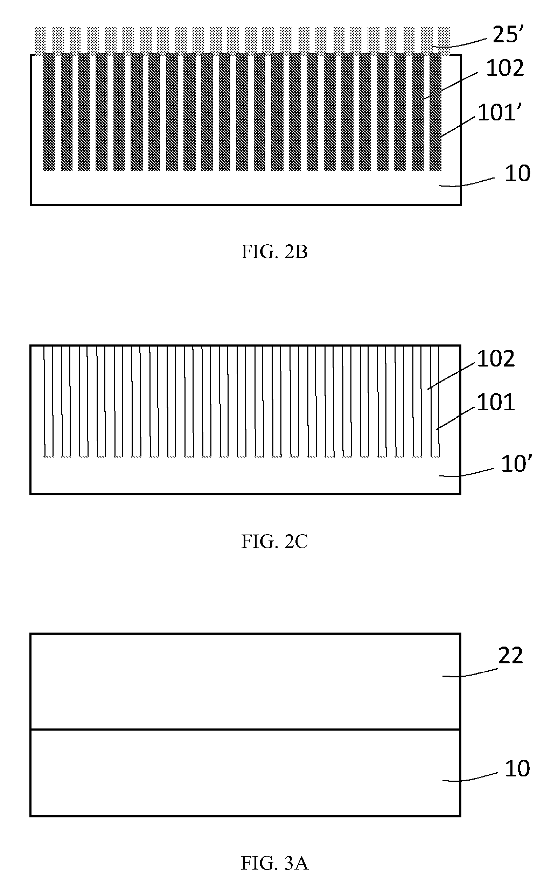

Also shown in FIGs. 2A-2C is another approach to make porous material according to one aspect of the present invention. In FIG. 2A, a standard nanoprint lithographic process is applied to form a mask 25' over a substrate 10. A review of nanoprint lithography can be found in US patent No. 7,604,903 and references therein, which are herein incorporated by reference in their entirety. The substrate 10 with mask 25' is then subjected to ion implantation with predetermined ions and implantation doses. Ions 70 are implanted into substrate 10 through mask 25', producing highly damaged and defective micro- or nano-zones 101' illustrated in FIG. 2B. To enhance the damage to substrate 10, the ion implantation process can be performed at elevated temperatures, for example, ion implantation can be done while heating substrate 10 up to 500 °C. Hydrogen, helium, nitrogen, oxygen and the like ions with a dose over 10¹² cm⁻² (for example from 10¹² _{CM}-2 to loll cm₋²) with an implantation time over 2 minutes (for example from 1 to 60 min) and ion energy over 50 KeV (for example from 20 KeV to 300 KeV) can be applied in some embodiments to form highly defective micro- or nano-zones 101' in FIG. 2B. The depth and collimation for the damaged zones 101' can be optimized by the ion implantation parameters such as implantation ion types, ion dose, ion energy, implantation temperature and time.

The ion damaged zones 101' can be removed by methods like wet chemical etching, for example, by KOH solution etching. KOH solution will have a highly selective etching rate for the nano zones 101' over the undamaged zones 102. Because of the very high-density defects or the amorphous nature of zones 101', materials in zone 101' are selectively etched away by KOH solution, leaving un-etched zones 102 and pores 101 forming a highly porous structure with substantially vertically continuous pores 101 shown in FIG. 2C. The pore density of the mask 25' can be over 10⁶ cm⁻², or over 10⁸ cm⁻², or even over 10⁹ cm⁻², preferably in the range 1 Og cm⁻² to 10⁹ cm⁻² , and the average diameter or size of the pores can be in the range of 0.2-10 µm. The pores 101 of substrate 10' have a similar density and dimension to that of mask 25'. The depth of the pores 101 may be adjusted by varying the ion implantation and etching conditions such as etching time and temperature and can be in the range of 5-100 gm, for example, 5-10 gm in some embodiments, 50-100 µm in some other embodiments.

FIGs. 3A-3G illustrate an in-situ porous nitride formation process. Using an epitaxial growth reactor such as a metalorganic chemical vapor deposition (MOCVD) reactor, a template layer 22 which can be made of GaN, AlGaN, InGaN, or the like is deposited over substrate 10 which can be made of GaN, Si, SiC, sapphire, or the like. The thickness of template layer 22 can be in the range of 1-10 um The growth conditions used for template layer 22 formation are optimized to obtain high-quality nitride layers. For example, the growth pressure can be kept relatively low favoring two-dimensional layer formation, in the range of 100 to 500 torr. And the growth temperature is in the range of 950 to 1150 °C, again favoring two-dimensional growth as well as suppressing contaminants incorporation.

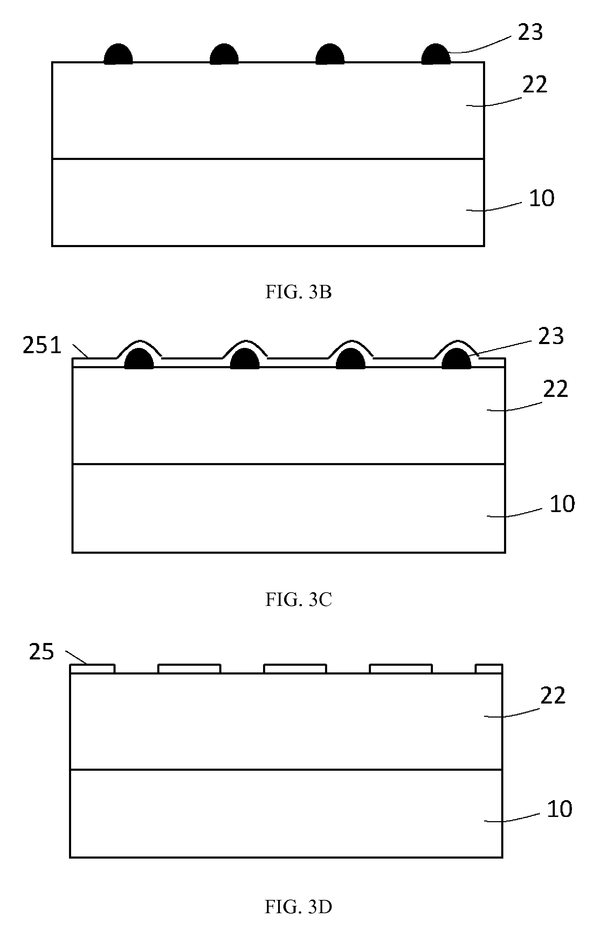

Upon the formation of template layer 22 (FIG. 3A), the growth temperature is lowered down to 500-750 °C and the growth pressure is raised up to 200-760 torr, favoring three dimensional (island) growth of indium-containing material such as InGaN, AIInGaN and the like. Under such a growth condition, indium-containing islands 23 such as high-indium-fraction (in the range of 10%-50%) InGaN or AlInGaN islands are formed over template layer 22, as shown in FIG. 3B. These indium-containing islands 23 can be controlled via metalorganic flows and growth time to be of a diameter or size of 5-50 nm, with a density of 10⁸-10¹⁰ cm⁻².

Then a mask layer 251 such as silicon nitride or silicon dioxide is formed, preferably in situ, over the exposed surface of template layer 22 as well as the surface of indium-containing islands 23 (shown in FIG. 3C). Mask layer 251 is preferred to have a thickness in the range of 50-200 nm, to have a solid coverage over the exposed surface of template layer 22.

In FIG. 3D, the substrate 10 is heated up, to a temperature greater than 850 °C, to remove the indium-containing islands 23 and portions of mask layer 251 that cover islands 23 by quick thermal dissociation, because the indium-containing islands such as InGaN islands have a relatively low dissociation temperature (below 850 °C for InGaN with indium fraction larger than 10% ). This process results in a nanomask 25 covering the surface of template layer 22, as shown in FIG. 3D. At this step, substrate 10 should not be heated to such a high temperature that would overly damage the rest portions of mask layer 251.

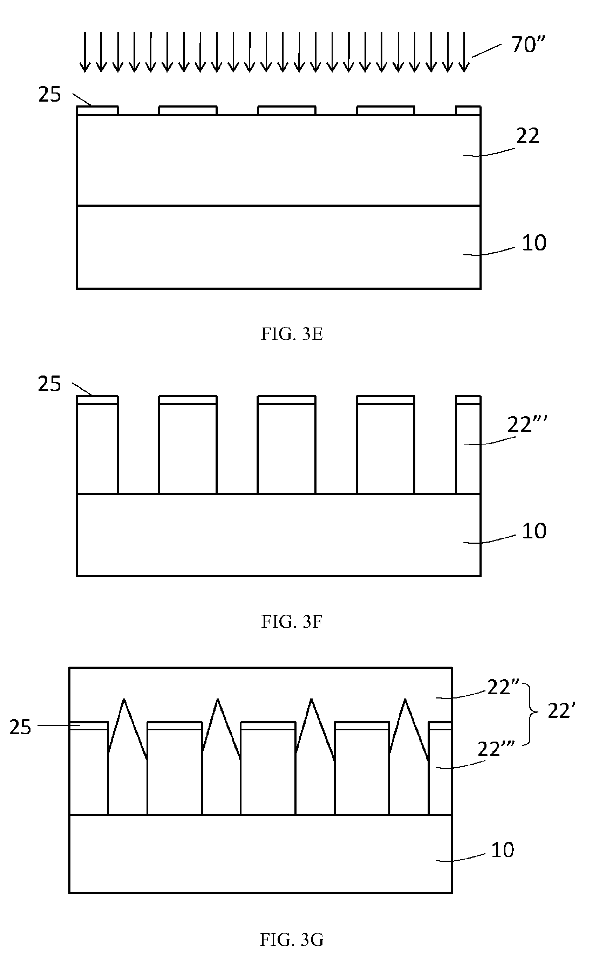

In FIG. 3E, by introducing etchant gas 70" such as HCI, and maintaining an etch temperature around 1000-1050 °C, a vertically aligned porous intermediate template layer 22"' is formed in FIG. 3F. During etching, ammonia and other metalorganic flows are preferred to be stopped to avoid any metal droplet formation on the surface. In general, through the control of HCl flow, etch time, etch temperature and etch pressure, a porous intermediate template layer 22"' with substantially vertically continuous pores is formed with the desired thickness and porosity. Preferred etch temperature is from 1000-1050 °C, etch time from 5-20 minutes, etch pressure from 100 to 760 torr. Preferred etchant HCl flow is 5-50 seem. The pore density of porous intermediate template layer 22"' is a replica of that of islands 23, can be over 10⁸ cm⁻² or even over 10⁹ cm⁻², preferably in the range 1 Og cm⁻² to 10⁹ cm⁻² . The average diameter or size of the pores can be in the range from 5 to 50 nm. The average depth of the substantially vertically continuous pores can be in the range of 1-10 um The vertical continuous pores in porous intermediate template layer 22"' can be through pores to expose the surface of substrate 10 as shown in FIG. 3F, or can be non-through pores without exposing substrate 10.

In FIG. 3G, growth is resumed to have a recovered, flat surface for the following LED structure growth. As shown, with a regrowth layer 22", the pores openings of porous intermediate template layer 22"' are zipped or sealed by the nitride lateral growth. Regrowth layer 22" can be made of GaN, InGaN, AlGaN, or the like, can be made of the same or different material from that of template layer 22, and may have a thickness of 1-5 µm. The so-formed porous template layer 22', which contains porous intermediate template layer 22"', nanomask 25 and regrowth layer 22", can have a reduced dislocation density, because of the dislocation bending effect during the porous front coalescence, and also can have enhanced light extraction efficiency because of the increased diffuse reflection of light.

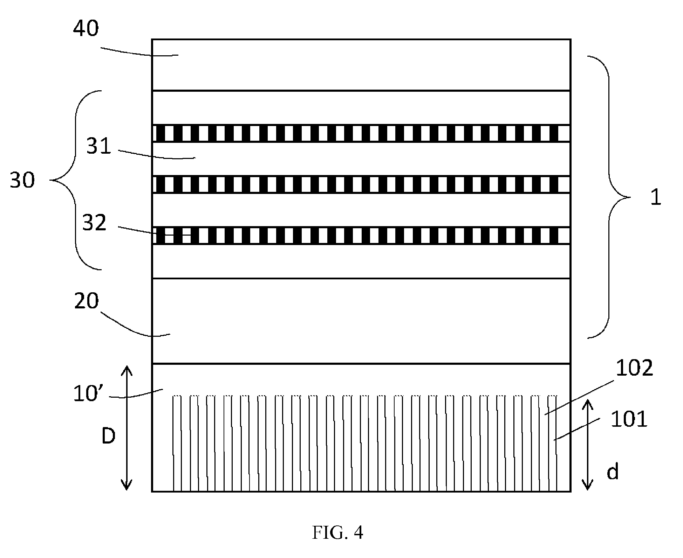

Shown in FIG. 4 is the cross-sectional schematic diagram of an embodiment according to the present invention. A light-emitting structure 1 includes at least an n-type layer 20, a p-type layer 40, and an active-region 30 sandwiched there between. Active-region 30 includes at least one barrier 31 and at least one well 32. Active-region 30 can be a multiple quantum well (MQW) structure. N-type layer 20 can be Si-doped GaN, AlGaN, or low-In-fraction InGaN with an indium molar faction less than 10%. P-type layer 40 can be Mg-doped GaN, AlGaN, or low-In-fraction InGaN with an indium molar fraction less than 10%. Barriers 31 are preferably to be Si-doped GaN, or low-In-fraction InGaN with an indium molar fraction less than 10%. Quantum wells 32 are preferably to be made of InGaN. The light-emitting structure 1 sits on a substrate 10', which has a porous portion. Porous substrates of the present invention comprise high-density pores, preferably vertically continuous pores, and solid walls separating the pores. The thickness d of the porous portion is at least one tenth of the thickness D of the substrate. Preferably, d is at least one fifth of D; more preferably, at least one third of D. The porous portion of the substrate of the present invention contains high-density micro- or nano- pores extending substantially vertically, or substantially perpendicular to the top surface of the substrate. Preferably these pores continuously extend upwards without break. The pore density can be over 10⁶ cm⁻², or over 10⁸ cm⁻², or even over 10⁹ cm⁻² . The thickness of the upper solid portion of substrate 10' which is D-d in the structure shown in FIG. 4 can be in the range of nine tenths to one third of D. The average diameter of the pores of substrate 10' can be in the range 0.2 to 10 um The average depth of the substantially vertically continuous pores 101 can be in the range 5-100 um The materials suitable for the substrate of this invention include GaN, SiC, Si, sapphire and the like.

Still referring to FIG. l, FIG. 2 and FIG. 4, the so-formed porous substrate 10' is cleaned and dried before being loaded into an epitaxy reactor such as a metalorganic chemical vapor deposition (MOCVD) reactor. The epitaxial growth surface of substrate 10' can be porous, i.e., pores 101 are through pores (D = d). However, in the embodiment shown in FIG. 4 it is preferred to be epi-ready and flat surface without porosity. Substrate 10' is heated up by a susceptor (not shown in FIG. 4) holding the substrate 10' to a high temperature for the growth of n-layer 20, such as an n-GaN layer. This growth temperature is usually above 950 °C, high enough to wipe out the temperature non-uniformity arising from the non-uniform thermal conductivity of substrate 10' caused by the "porosity". However, when the susceptor temperature is lowered down to, say, 500-750 °C, for indium-containing active-region 30 growth, the non-uniform thermal conductivity of the porous substrate 10' can result in two dimensional temperature fluctuations on the growth surface for active-region growth. The temperature of a surface area sitting above a pore 101 can be lower than the temperature of a surface area sitting on a solid wall 102 during the active-region growth by 1 °C or more, through optimizing the porous portion thickness, d, and the porosity to modulate heat flow transferred from the susceptor to substrate 10'. If D-d approaches D, there is no 2D temperature modulation at all. If D-d=0, there is the maximized 2D temperature modulation. Also, if temperature is too high, for example, higher than 950 °C, heat can be transferred to growth surface via conduction as well as radiation, therefore the difference in thermal conductivity of the porous substrate 10' plays a less important role in the 2D temperature modulation. If heat is mainly transferred to growth surface via conduction from the susceptor and porous substrate 10', for example, for a temperature in the range of 500-750 °C, the difference in thermal conductivity of substrate 10' will play a greater role in the 2D temperature modulation.

This 2D temperature deviation on the growth surface can affect indium incorporation in indium-containing quantum wells 32, resulting in InGaN epilayers with 2D fluctuational composition, because indium incorporation in nitride (such as InGaN) layer growth is very temperature-sensitive. 1 °C temperature difference during InGaN epitaxial growth could result in more than 1 % difference in indium composition in the InGaN layer. Therefore, the active-region 30 shown in FIG. 4 can have InGaN quantum wells 32 with micro- or nano-scale composition fluctuation in the quantum well plane. Quantum wells 32 in this sense are equal to quantum dots, enabling the highest light-generation efficiency. The active-region 30 therefore has a composition fluctuation structure which has a pattern that is the same as or similar to the pattern of pores 101 in substrate 10'. Thus active-region 30 provides an improved quantum confinement effect compared to the quantum wells used in the prior art. Although according to the embodiment depicted in FIG. 4, n-layer 20 is directly disposed on the porous substrate 10', p-layer 40 may instead be directly disposed on the porous substrate 10' according to another embodiment. In other words, p-type layer 40, active-region 30, and n-type layer 20 may be formed sequentially on the surface of the porous substrate 10'.

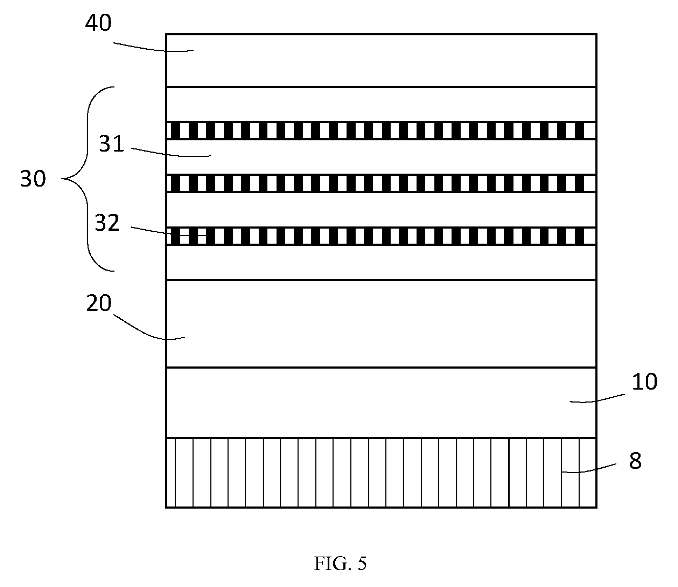

Alternatively, another approach of generating 2D temperature fluctuation on a growth surface is shown in FIG. 5. Substrate 10 in FIG. 5 is coated, or bonded with porous material 8 with good thermal conductivity, for example, having a thermal conductivity larger than 23 W/m°C. The porous material 8 can be selected from BeO, SiC, silicon, anodic alumina or the like. The porous material 8 provides non-uniform thermal conductivity because of its porous feature. This can generate 2D temperature non-uniformity on the growth surface during the growth of InGaN quantum wells 32, which can cause the fluctuation of indium composition in InGaN quantum wells 32 along the 2D growth surface and exert additional quantum confinement besides that from the quantum barriers 31 for carriers injected into quantum wells 32. The substrate 10 may be bonded to a porous surface or a non-porous surface of porous material 8. The thicknesses of substrate 10 and porous material 8 can be in the range of 50-100 uᵣn, and 50-200 µm, respectively. Although according to the embodiment depicted in FIG. 5, n-layer 20 is directly disposed on substrate 10, p-layer 40 may instead be directly disposed on substrate 10 according to another embodiment. In other words, p-type layer 40, active-region 30, and n-type layer 20 may be formed sequentially on the surface of substrate 10. Porous material 8 can be made as described in FIGs. 1 and 2A-2C and may have a porous structure similar to those shown in FIGs. 1 and 2A-2C, e.g., with a pore size or diameter from 200 nm to 10 micron and a pore density from 10⁶ to 10⁹ cm⁻².

Porous material 8 in FIG. 5 can also be a susceptor holding substrate 10 for LED structure growth. A susceptor or a portion of a susceptor with micro and/or nano pores, for example of a pore size or diameter from 200 nm to 10 micron and a pore density from 10⁶ to 10⁹ cm⁻², can be used to hold substrate 10, having the porous portion in direct and conformable contact with substrate 10.

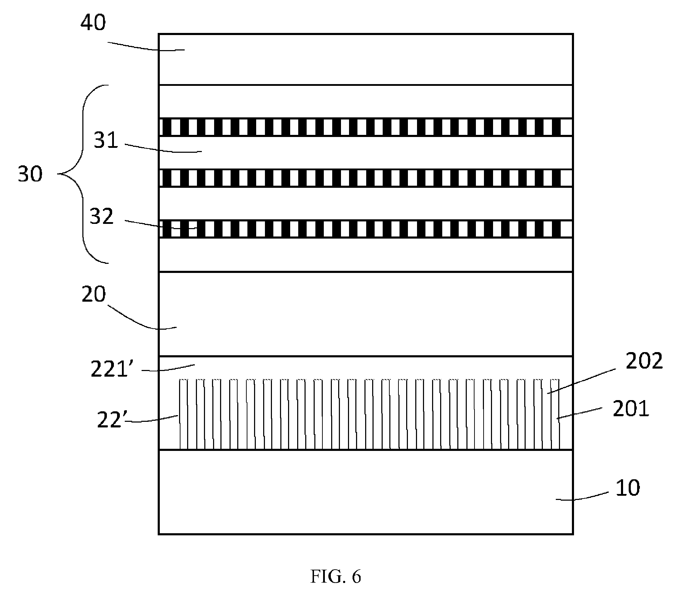

The vertical porous structure can also be formed in a growth template layer 22' as shown in FIG. 6 according to another embodiment of the present invention. In FIG. 6 the template layer 22' has pores 201 and solid walls 202 similar to those described in FIGs. 1 and 2A-2C and can be made of GaN, or InGaN, or AlGaN such as low-Al-fraction AlGaN having Al molar fraction less than 10%. Using the method described in FIG. 1 or FIGs. 2A-2C, GaN, or AIGaN, or InGaN template layer grown on a substrate can be converted into the porous template layer 22' shown in FIG. 6. That is to say, a template layer grown on a substrate is converted to a porous template layer 22' via a nano-masking process and a material removal mechanism such as laser ablation explained in FIG. 1 and ion implantation and wet chemical etching explained in FIGs. 2A-2C. Before the growth of n-layer 20, a smoothening layer 221', preferably of 1-5 ᵤrn thickness, is deposited on top of the porous template layer 22' to smooth the growth surface for the following light-emitting structure growth. The smoothening layer 221' can be made of the same or different material as that of template layer 22'. The thickness of this porous template layer 22' can be in the range of 1 to 10 microns, or in the range of 1-5 microns, with a pore size of 0.2 to 1 micron. This porous template layer 22' because of its close positioning to the active-region 30, within only a distance of 3-10 microns which is the thickness sum of the smoothening layer 221' and n-layer 20, can have a significant effect on the temperature distribution on the growth surface during the growth of active-region 30. This template layer 22' can generate a 2D temperature non-uniformity on the growth surface during the growth of indium-containing, such as InGaN, quantum wells 32, which can cause the fluctuation of indium composition in indium-containing quantum wells 32 along the 2D growth surface and exert additional quantum confinement besides that from the quantum barriers 31 for carriers injected into quantum wells 32.

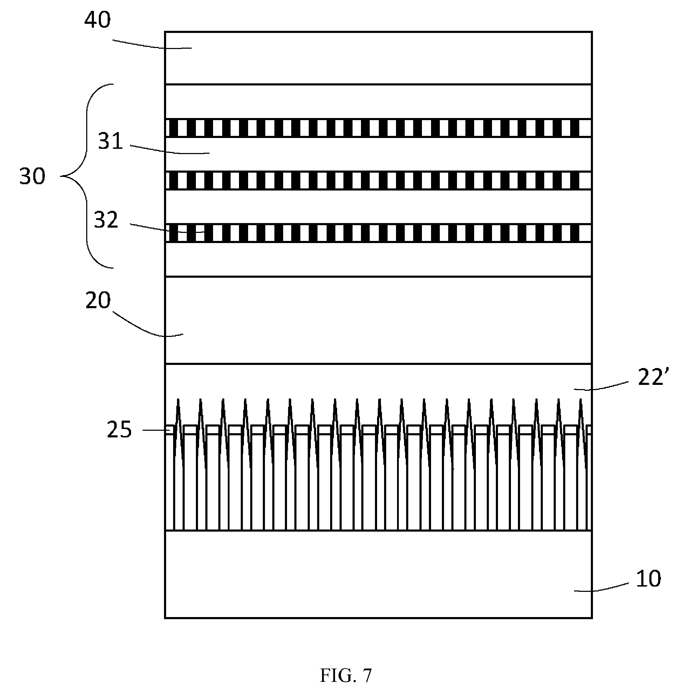

This porous template layer 22' can also be formed in situ as described in FIGs. 3A-3G. After the formation of porous template layer 22' as shown in FIGs. 3F-3G, ammonia and metalorganic flows are resumed to epitaxially grow a smoothening or recovering n-type layer 20 without removing nanomask layer 25. N-type layer 20 is preferred to be made of Si-doped GaN and is intended to smoothen and recover any roughness from the porous layer 22'. The thickness of n-type layer 20 in the structure as shown in FIG. 7 can be in the range of 1-10 microns. Then a light emitting structure containing an active-region with indium-containing quantum well(s) such as InGaN well is formed over the smoothening n-type layer 20 as shown in FIG. 7. This porous template layer 22' because of its close positioning to the active-region 30, within only a distance of 1-10 microns (which is the thickness of the smoothening n-layer 20), can have a significant effect on the temperature distribution during the growth of active-region 30. This porosity of template layer 22' can imprint 2D temperature non-uniformity during the growth of InGaN quantum wells 32, which can cause the fluctuation of indium composition in InGaN quantum wells 32 along the 2D growth surface and exert additional quantum confinement besides that from the quantum barriers 31 for carriers injected into quantum wells 32. Here, the porous template layer 22' can have a thickness from 1 to 10 micron, a pore size from 5 nm to 50 nm, and a pore density from 10⁶ to 10⁹ cm⁻², preferably from 10⁸ to 10⁹ cm⁻².

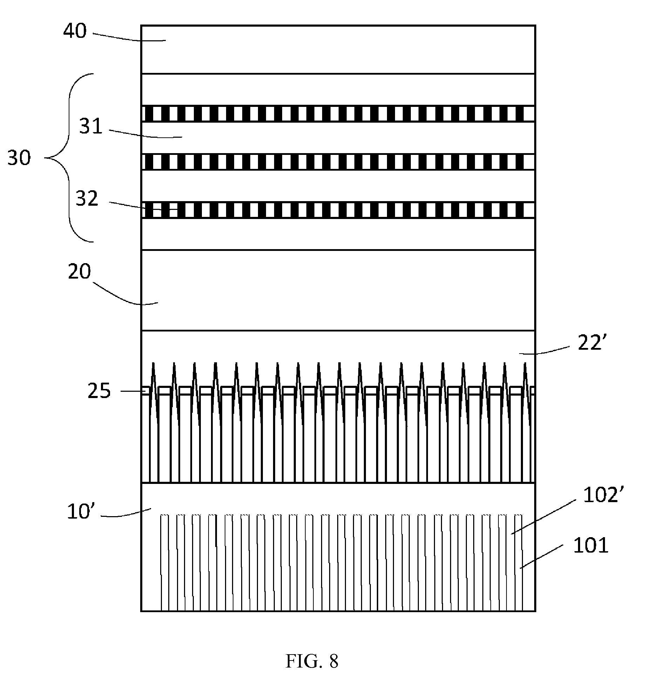

Still another embodiment according to the present invention is shown in FIG. 8, where a substrate 10' has a porous portion of substantial thickness. Substrate 10' can be formed by methods described in FIG. 1 and FIGs. 2A-2C. The surface of substrate 10' is preferred to be an epi-ready surface. A porous template layer 22' is formed in-situ on substrate 10' as described above in connection with FIGs. 3A-3G. Smoothening n-type layer 20 and active-region 30 can be formed as described above in connection with FIG. 7. The combination of porous substrate 10' and porous template layer 22' is intended to give a greater impact on the indium composition 2D fluctuation of the quantum wells 32.

It will be apparent to those skilled in the art that various modifications and variations can be made to the disclosed embodiments without departing from the scope or spirit of the invention. In view of the foregoing, it is intended that the invention cover modifications and variations of this invention provided they fall within the scope of the following claims and their equivalents.

## Claims

1. A method for fabricating a light-emitting device comprising:
forming pores in a substrate with a pore density from 10⁶ to 10⁹ _{c}rri ²;
depositing an n-type layer on the substrate;
forming an active-region comprising at least one indium-containing quantum well layer on the n-type layer, wherein indium composition of the indium-containing quantum well layer fluctuates in a growth surface from which the active-region grows; and
depositing a p-type layer on the active-region;
wherein the pores are configured to cause temperature fluctuation along a growth surface during epitaxial growth of the indium-containing quantum well layer on the growth surface that, in turn, causes the fluctuation of the indium composition of the indium-containing quantum well layer.

2. The method according to claim 1, wherein the step of forming pores in the substrate comprises:
forming an anodic alumina mask on the substrate;
subjecting the substrate with the anodic alumina mask to a scanning laser beam to form the pores in the substrate; and
removing the anodic alumina mask.

3. The method according to claim 1, wherein the step of forming pores in the substrate comprises:
forming a mask on the substrate by a nanoprint lithographic process;
subjecting the substrate with the mask to ion-implantation to form defective zones in the substrate;
removing the defective zones by a wet chemical etch process to form the pores in the substrate; and
removing the mask.

4. The method according to claim 3, wherein the ion implantation comprises implanting ions selected from the group consisting of hydrogen, helium, nitrogen, and oxygen ions with a dose over 10¹² cm-² , an implantation time over 2 minutes, and an ion energy over 50 KeV.

5. A method for fabricating a light-emitting device comprising:
forming a porous template layer with a pore density from 10⁶ to 10⁹ _{C}m-2 on a substrate;
depositing an n-type layer on the porous template layer;
forming an active-region comprising at least one indium-containing quantum well layer on the n-type layer, wherein indium composition of the indium-containing quantum well layer fluctuates in a growth surface from which the active-region grows; and
depositing a p-type layer on the active-region;
wherein the pores of the porous template layer are configured to cause temperature fluctuation along a growth surface during epitaxial growth of the indium-containing quantum well layer on the growth surface that, in turn, causes the fluctuation of the indium composition of the indium-containing quantum well layer.

6. The method according to claim 5, wherein the step of forming the porous template layer comprises:
depositing a template layer on the substrate;
depositing indium-containing islands over the template layer;
depositing a mask layer on the template layer and the indium-containing islands;
subjecting the mask layer and the indium-containing islands to a temperature sufficient to remove the indium-containing islands and portions of the mask layer that cover the indium-containing islands through thermal dissociation, so as to form a patterned mask layer exposing portions of the template layer;
etching the template layer by an etchant gas to form the porous template layer through the patterned mask layer.

7. The method according to claim 6, wherein the indium-containing islands have a size of 5-50 nm, a density from 10⁸ to 10⁹ cm⁻² , and are made of InGaN with an indium composition from 10% to 50%.

8. The method according to claim 6 or claim 7, wherein the mask layer and the indium-containing islands are subjected to a temperature above 850 °C.

9. The method according to any one of claims 6 to 8, wherein the mask layer is of thickness from 50-200 nm.

10. The method according to any one of claims 6 to 9, further comprising forming a regrowth layer to seal openings of pores of the porous template generated in the step of etching the template layer.

11. The method according to any one of claims 6 to 10, wherein the mask layer is made silicon nitride, or silicon dioxide.
